# DEMANDE DE BREVET EUROPEEN

(11) **EP 3 624 192 A1**
(43) Date de publication de la demande: **18.03.2020**
(21) Numéro de dépôt: 19196051.7
(22) Date de dépôt: 06.09.2019
(51) Int. Cl.: H01L 27/15, H01L 33/00, H01L 33/38, H01L 33/62, H01L 33/08

(54) **PROCÉDÉ DE FABRICATION D'UN DISPOSITIF OPTOÉLECTRONIQUE COMPRENANT UNE PLURALITÉ DE DIODES**

(30) Priorité: 13.09.2018 FR 1858201
(71) Demandeur: Commissariat à l'Energie Atomique et aux Energies Alternatives, 75015 Paris (FR)
(72) Inventeur: BONO, Hubert, 38054 GRENOBLE CEDEX 9 (FR); SIMON, Julia, 38054 GRENOBLE CEDEX 9 (FR)
(74) Mandataire: Cabinet Beaumont

(57) **Abrégé**

L'invention concerne un procédé de fabrication d'un dispositif optoélectronique, comportant :
a) rapporter, sur une face de connexion d'un circuit de contrôle (110), un empilement de diode (150) comportant des première (153) et deuxième (157) couches semiconductrices de types de conductivité opposés, de façon que la deuxième couche semiconductrice (157) de l'empilement soit tournée vers la face de connexion du circuit de contrôle et soit séparée de la face de connexion du circuit de contrôle par une couche isolante (118, 161) ;
b) former dans l'empilement des tranchées (173) délimitant une pluralité de diodes (176), les tranchées se prolongeant à travers la couche isolante (118, 161) et débouchant sur la face de connexion du circuit de contrôle (110) ; et
c) former dans les tranchées (173) des métallisations (183) connectant la deuxième couche semiconductrice (157) à la face de connexion du circuit de contrôle (110).

## Description

### Domaine

La présente demande concerne le domaine des dispositifs optoélectroniques. Elle concerne plus particulièrement un procédé de fabrication d'un dispositif optoélectronique comportant une pluralité de diodes semiconductrices, par exemple au nitrure de gallium, et un circuit électronique de contrôle de ces diodes.

### Exposé de l'art antérieur

On a déjà proposé un dispositif d'affichage émissif comportant une matrice de diodes électroluminescentes (LED) au nitrure de gallium (GaN), et un circuit de contrôle permettant de commander individuellement les LED pour afficher des images.

Pour réaliser un tel dispositif, on peut prévoir de fabriquer séparément le circuit de contrôle et la matrice de LED, puis de les hybrider, c'est-à-dire de les empiler en les connectant l'un à l'autre.

Un inconvénient de cette méthode de fabrication réside dans la nécessité d'aligner précisément le circuit de contrôle et la matrice de LED lors de l'étape d'assemblage de ces deux éléments, de façon que chaque LED vienne bien se positionner sur un plot métallique qui lui correspond dans le circuit de contrôle. Cet alignement est notamment difficile à réaliser lorsque le pas des pixels diminue, et constitue un frein à l'augmentation de la résolution et/ou de la densité d'intégration des pixels.

Pour pallier cet inconvénient, il a été proposé, notamment dans la demande de brevet internationale N°WO2017194845 (DD16946/B15015) déposée par le demandeur le 13 mai 2016, et dans la demande de brevet français N°17/60578 (DD17951/B16061) déposée par le demandeur le 10 novembre 2017, de :
réaliser d'abord le circuit de contrôle sous la forme d'un circuit intégré comportant, sur une face, une pluralité de plots métalliques destinés à être connectés aux LED de façon à permettre de contrôler individuellement le courant circulant dans chaque LED ;
reporter ensuite sur la face du circuit de contrôle comportant les plots métalliques un empilement actif de LED s'étendant de façon continue sur toute la surface du circuit de contrôle de façon à connecter une couche semiconductrice de l'empilement aux plots métalliques du circuit de contrôle ; puis
structurer l'empilement actif de LED pour délimiter et isoler les unes des autres les différentes LED du dispositif.

Un avantage de ce procédé de fabrication est que, lors de l'étape de report de l'empilement actif de LED sur le circuit de contrôle, les positions des différentes LED du dispositif dans l'empilement actif ne sont pas encore définies. Il n'y a par conséquent pas de contrainte forte en termes de précision d'alignement lors du report. La délimitation des différentes LED dans l'empilement actif peut ensuite être réalisée par des procédés de structuration d'un substrat et de dépôt de couches isolantes et conductrices sur un substrat, qui offrent une précision d'alignement nettement supérieure à la précision qui peut être obtenue lors d'un report d'un substrat sur un autre.

Il serait toutefois souhaitable d'améliorer au moins en partie certains aspects des procédés décrits dans la demande de brevet internationale N°WO2017194845 et dans la demande de brevet français N°17/60578 susmentionnées.

En particulier, dans les procédés décrits dans les demandes de brevet susmentionnées, lors de l'étape de report de l'empilement actif de LED sur le circuit de contrôle, le collage (bonding) de l'empilement actif de LED sur le circuit de contrôle doit être adapté non seulement à fixer mécaniquement l'empilement actif sur le circuit de contrôle, mais aussi à connecter électriquement l'empilement actif à chacun des plots métalliques du circuit de contrôle. En pratique, un tel collage est difficile à réaliser.

Dans les demandes de brevet susmentionnées, il a notamment été proposé, avant le report de l'empilement actif de LED sur le circuit de contrôle, de déposer une première couche métallique sur la face de connexion du circuit de contrôle, et de déposer une deuxième couche métallique sur la face de l'empilement destinée à être mise en contact avec le circuit de contrôle. L'empilement actif de LED est ensuite fixé sur le circuit de contrôle par collage moléculaire ou collage direct de la première couche métallique sur la deuxième couche métallique. Dans la pratique, on constate toutefois que le collage de la première couche métallique (côté circuit de contrôle) sur la deuxième couche métallique (côté empilement actif de LED) n'est pas toujours parfait. Plus particulièrement, il peut exister, à l'interface entre le circuit de contrôle et l'empilement actif de LED, des zones dans lesquelles les première et deuxième couches métalliques ne sont pas en contact. Si ces défauts de collage ne posent en pratique pas de problème de tenue mécanique, ils peuvent conduire in fine à des défauts de connexion électrique entre le circuit de contrôle et certaines LED du dispositif. En particulier, certains pixels peuvent être rendus inutilisables du fait d'un défaut voire d'une absence de connexion électrique entre la LED et le circuit de contrôle.

### Résumé

Ainsi, un mode de réalisation prévoit un procédé de fabrication d'un dispositif optoélectronique, comportant les étapes suivantes :
a) rapporter, sur une face de connexion d'un circuit de contrôle(110), un empilement actif de diode comportant au moins des première et deuxième couches semiconductrices dopées de types de conductivité opposés, de façon que la deuxième couche semiconductrice de l'empilement soit tournée vers la face de connexion du circuit de contrôle et soit séparée de la face de connexion du circuit de contrôle par au moins une couche électriquement isolante ;
b) former dans l'empilement actif des tranchées délimitant une pluralité de diodes, les tranchées se prolongeant en outre à travers ladite au moins une couche isolante et débouchant sur la face de connexion du circuit de contrôle ; et
c) former dans les tranchées des premières métallisations connectant la deuxième couche semiconductrice de l'empilement à la face de connexion du circuit de contrôle.

Selon un mode de réalisation, le procédé comprend en outre la formation, dans les tranchées, de deuxièmes métallisations isolées des premières métallisations, en contact avec les flancs de la première couche semiconductrice.

Selon un mode de réalisation, le procédé comprend, successivement :
une première étape de formation partielle des tranchées jusqu'à un niveau intermédiaire de la première couche semiconductrice ;
une étape de dépôt d'une première couche métallique sur les parois latérales des tranchées ;
une étape de formation de premiers espaceurs en un matériau isolant sur les parois latérales des tranchées ;
une étape de prolongement des tranchées jusqu'à un niveau intermédiaire de la deuxième couche semiconductrice ;
une étape de formation de deuxième espaceurs en un matériau isolant sur les parois latérales des tranchées ;
une étape de prolongement des tranchées jusqu'à la face de connexion du circuit de contrôle ; et
une étape de dépôt d'une deuxième couche métallique sur les parois latérales des tranchées,
les premières métallisations étant formées dans la deuxième couche métallique et les deuxièmes métallisations étant formées dans la première couche métallique.

Selon un mode de réalisation, le procédé comporte en outre, avant l'étape a) :
une étape de dépôt d'une première couche isolante sur toute la surface de la face de connexion du circuit de contrôle ; et
une étape de dépôt d'une deuxième couche isolante sur toute la surface de la deuxième couche semiconductrice de l'empilement actif de diode,
l'empilement actif de diode étant fixé au circuit de contrôle par collage direct de la première couche sur la deuxième couche, ladite au moins une couche isolante étant constituée par l'empilement des première et deuxième couches isolantes.

Selon un mode de réalisation, les première et deuxième couches isolantes sont en oxyde de silicium.

Selon un mode de réalisation, à l'étape a), l'empilement actif de diode est fixé au circuit de contrôle au moyen d'une couche en un matériau de collage électriquement isolant, constituant ladite au moins une couche isolante.

Selon un mode de réalisation, le matériau de collage électriquement isolant est une colle organique.

Selon un mode de réalisation, le procédé comprend en outre, avant l'étape a), une étape de dépôt d'une couche métallique sur et en contact avec toute la surface de la deuxième couche semiconductrice de l'empilement actif.

Selon un mode de réalisation, lors de la mise en oeuvre de l'étape a), l'empilement actif est supporté par un substrat de support situé du côté de la première couche semiconductrice opposé à la deuxième couche semiconductrice, le procédé comprenant en outre, entre l'étape a) et l'étape b), une étape de retrait du substrat de support.

Selon un mode de réalisation, les diodes semiconductrices sont des diodes électroluminescentes.

Selon un mode de réalisation, les diodes sont des photodiodes.

Selon un mode de réalisation, les première et deuxième couches semiconductrices sont des couches de nitrure de gallium, les diodes étant des diodes au nitrure de gallium.

Selon un mode de réalisation, le circuit de contrôle est formé dans et sur un substrat semiconducteur.

Un autre mode de réalisation prévoit un dispositif optoélectronique, comportant :
un circuit intégré de contrôle comportant une face de connexion ;
sur le circuit de contrôle, un empilement actif de diode comportant au moins des première et deuxième couches semiconductrices dopées de types de conductivité opposés, la deuxième couche étant séparées de la face de connexion du circuit de contrôle par au moins une couche isolante ;
des tranchées s'étendant dans l'empilement actif et délimitant dans l'empilement actif une pluralité de diodes ; et
dans les tranchées, des premières métallisations connectant la deuxième couche semiconductrice de l'empilement à la face de connexion du circuit de contrôle.

Selon un mode de réalisation, le dispositif comprend en outre, dans les tranchées, des deuxièmes métallisations isolées des premières métallisations, en contact avec les flancs de la première couche semiconductrice.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G, 1H, 1I, 1J, 1K, 1L, 1M, 1N et 1O sont des vues en coupe illustrant des étapes d'un exemple d'un mode de réalisation d'un procédé de fabrication d'un dispositif optoélectronique ; et
la figure 2 est une vue en coupe illustrant une variante du procédé des figures 1A à 1O.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la réalisation d'un circuit intégré de contrôle de diodes semiconductrices n'a pas été détaillée, les modes de réalisation décrits étant compatibles avec les structures et procédés de fabrication usuels de tels circuits de contrôle. De plus, la composition et l'agencement des différentes couches d'un empilement actif de diode semiconductrice n'ont pas été détaillés, les modes de réalisation décrits étant compatibles avec les empilements actifs usuels de diodes semiconductrices, notamment au nitrure de gallium. Dans la description qui suit, sauf indication contraire, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "latéral", etc., il est fait référence à l'orientation des figures correspondantes, étant entendu que, dans la pratique, les dispositifs et assemblages décrits peuvent être orientés différemment. Sauf précision contraire, les expressions "approximativement", "sensiblement", et "de l'ordre de" signifient à 10 % près, de préférence à 5 % près.

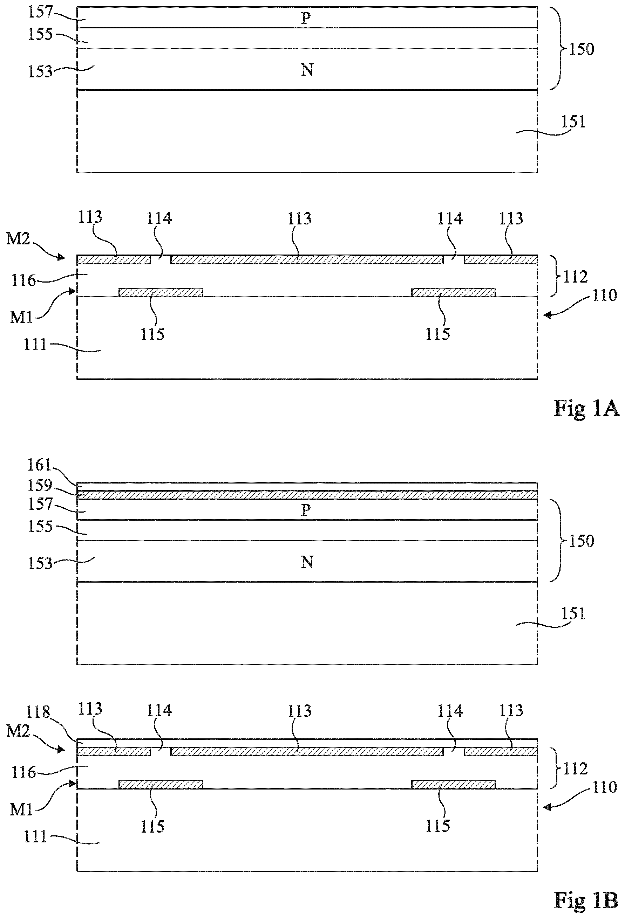

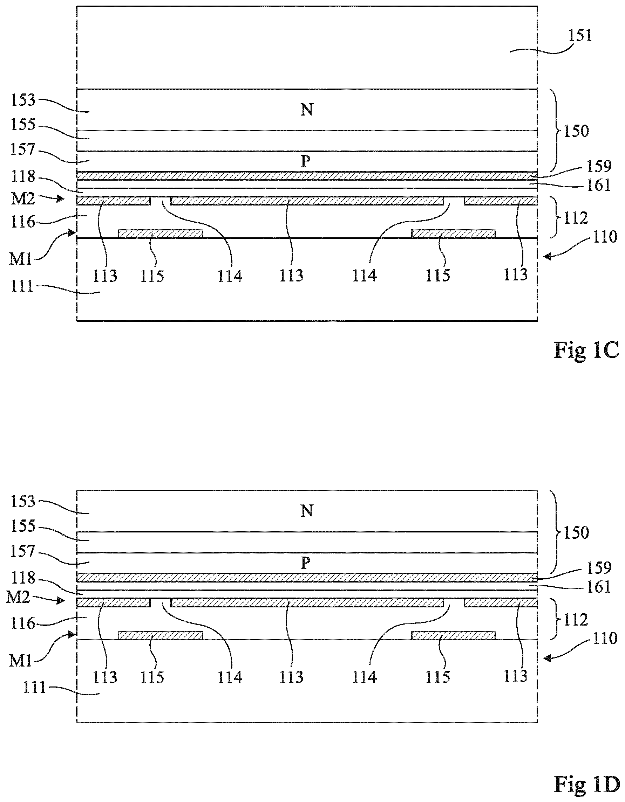

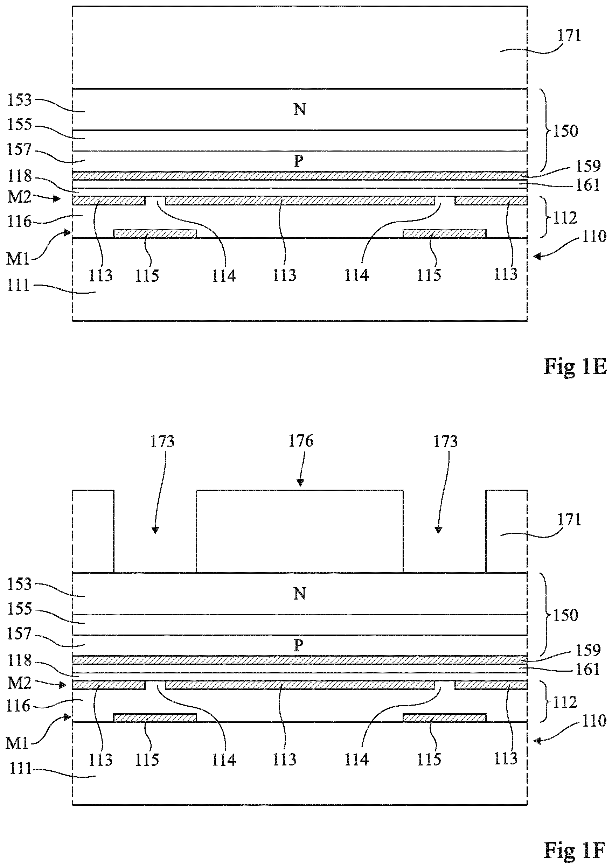

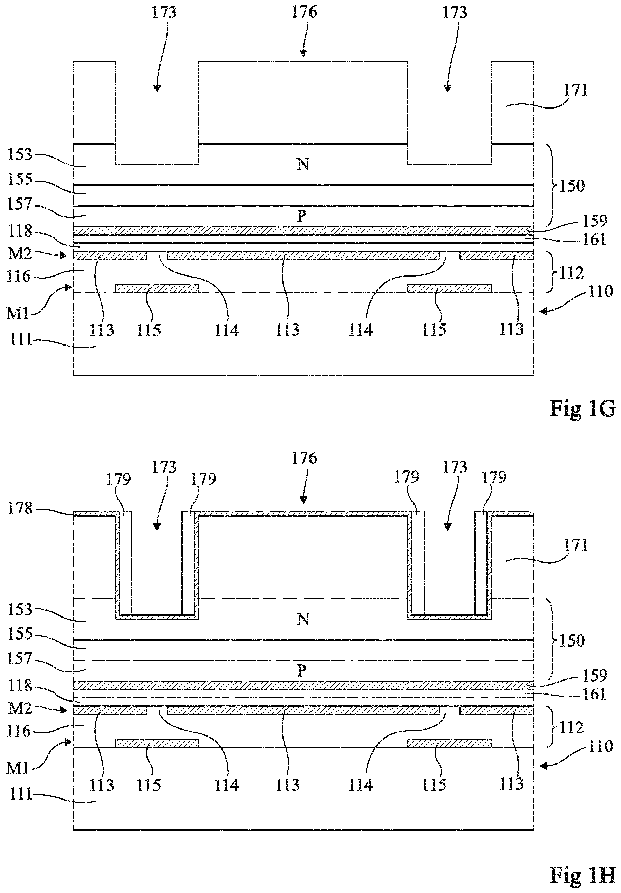

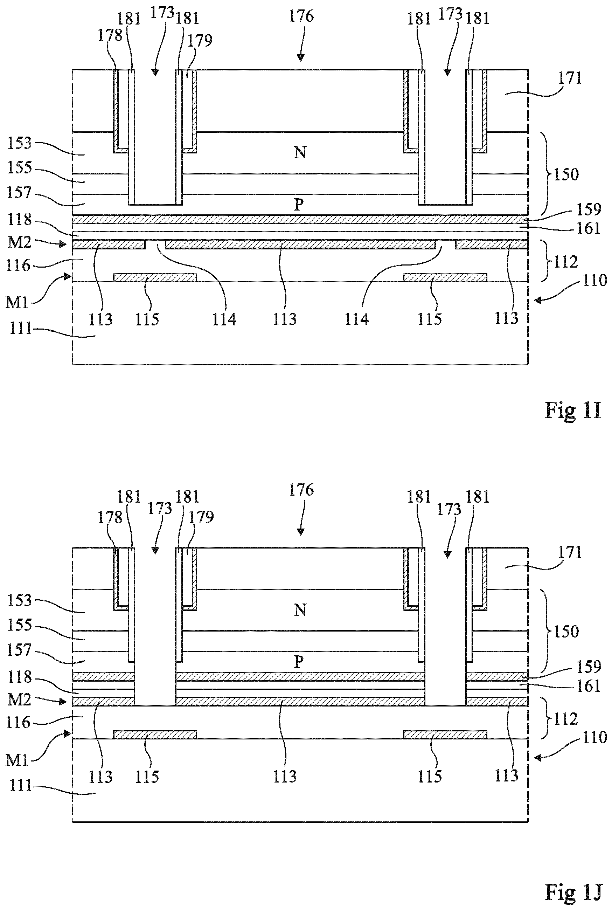

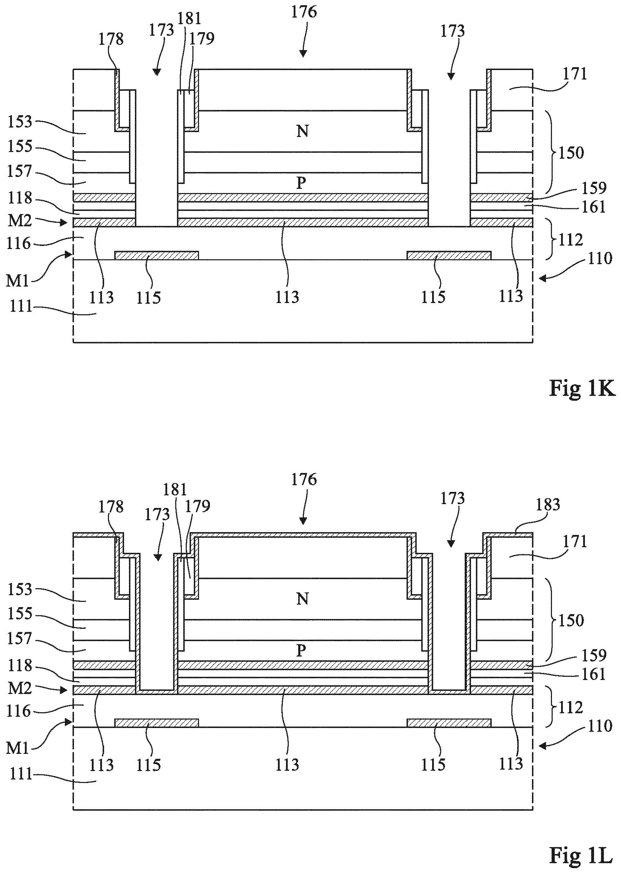

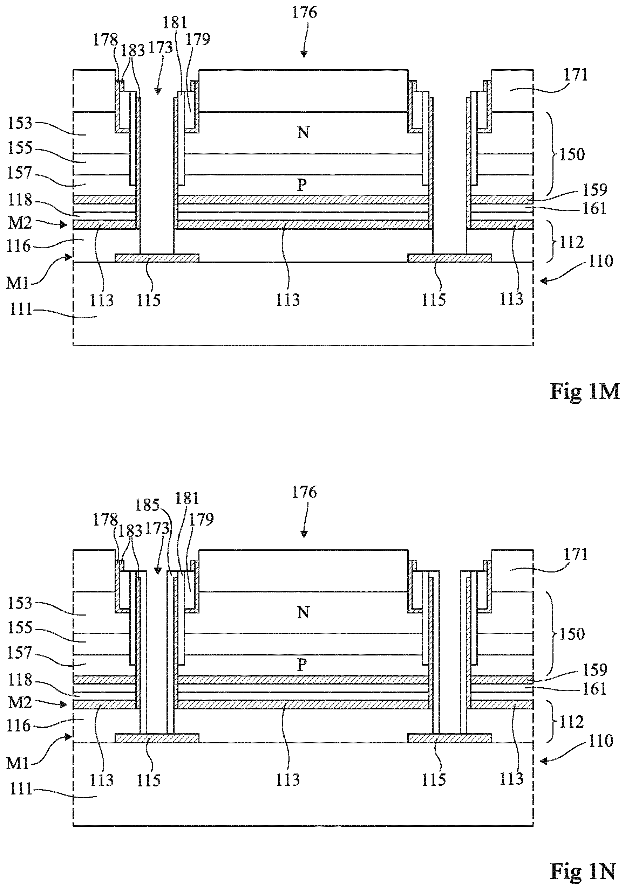

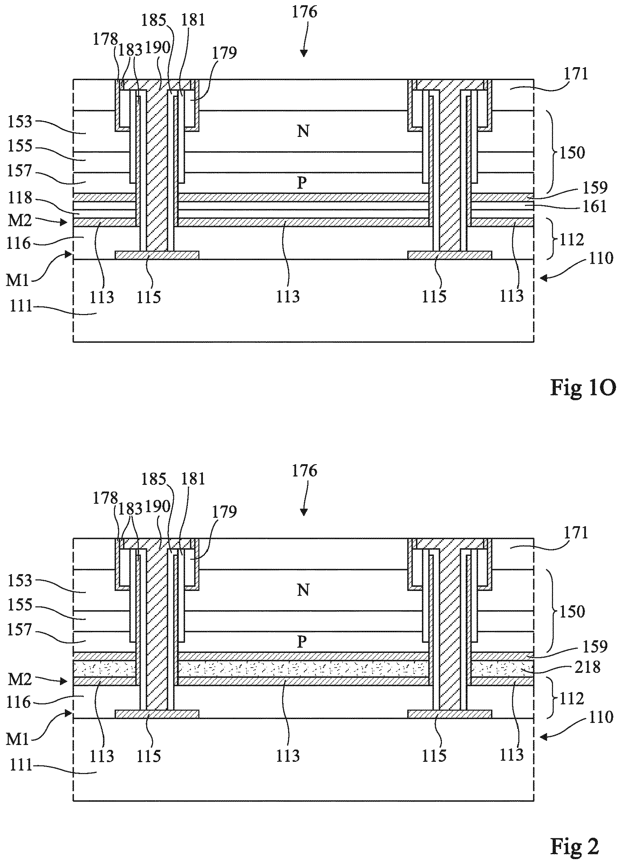

Les figures 1A, 1B, 1C, 1D, 1E, 1F, 1G, 1H, 1I, 1J, 1K, 1L, 1M, 1N et 1O sont des vues en coupe illustrant des étapes successives d'un exemple d'un mode de réalisation d'un procédé de fabrication d'un dispositif optoélectronique.

La figure 1A représente de façon schématique un circuit intégré de contrôle 110, préalablement formé dans et sur un substrat semiconducteur 111, par exemple un substrat en silicium. Dans cet exemple, le circuit de contrôle 110 comprend, du côté de sa face supérieure, un empilement d'interconnexion 112 comportant, pour chacune des LED du dispositif, un plot métallique de connexion 113 destiné à être connecté à l'une des électrodes (anode ou cathode) de la LED, de façon à pouvoir commander un courant circulant dans la LED et/ou appliquer une tension aux bornes de la LED. Le circuit de contrôle comprend par exemple, pour chaque LED, connectée au plot métallique 113 dédié à la LED, une cellule élémentaire de contrôle (non détaillée) comportant un ou plusieurs transistors, permettant de contrôler le courant circulant dans la LED et/ou une tension appliquée aux bornes de la LED. Le circuit de contrôle 110 est par exemple réalisé en technologie CMOS. Les plots métalliques 113 peuvent être latéralement entourés par un matériau isolant 114, par exemple de l'oxyde de silicium, de façon que le circuit de contrôle 110 présente une face supérieure (ou face de connexion) sensiblement plane comprenant une matrice de régions métalliques 113 séparées par des régions isolantes 114 (les régions isolantes 114 formant une grille continue séparant les rangées et colonnes de la matrice). A titre d'exemple, chaque plot métallique 113 a une largeur comprise entre 0,5 et 200 µm, et la largeur de la région isolante 114 entre deux plots métalliques 113 voisins est comprise entre 0,5 et 20 µm. Dans l'exemple représenté, l'empilement d'interconnexion 112 comprend en outre, pour chaque LED, une région métallique de connexion 115 destinée à être connectée à l'autre électrode (cathode ou anode) de la LED. Dans cet exemple, les régions de connexion 115 sont formées dans un niveau de métal M1, et les plots métalliques 113 sont formés dans un niveau de métal M2 supérieur au niveau M1, séparé du niveau M2 par une couche isolante 116, par exemple en oxyde de silicium. Les régions de connexion 115 sont disposées au moins en partie en vis-à-vis des régions isolantes 114 séparant latéralement les plots 113. A titre d'exemple, les régions de connexion 115 sont interconnectées de façon à former une grille métallique continue commune à tous les pixels du dispositif, disposée au moins en partie en vis-à-vis de la grille isolante formée par les régions 114.

La figure 1A représente en outre de façon schématique un empilement actif de LED 150, disposé sur la face supérieure d'un substrat de support 151. L'empilement 150 est par exemple un empilement de LED au nitrure de gallium. Le substrat de support 151 est par exemple un substrat en silicium, en saphir, en carbure de silicium, en nitrure de gallium, ou en tout autre matériau sur lequel un empilement actif de LED au nitrure de gallium peut être déposé. Dans l'exemple représenté, l'empilement actif comprend, dans l'ordre à partir de la surface supérieure du substrat 151, une couche de nitrure de gallium dopé de type N 153, une couche émissive 155, et une couche de nitrure de gallium dopé de type P 157. La couche émissive 155 est par exemple constituée par un empilement d'une ou plusieurs couches émissives formant chacune un puit quantique, par exemple à base de GaN, InN, InGaN, AlGaN, AlN, AlInGaN, GaP, AlGaP, AlInGaP, ou d'une combinaison d'un ou plusieurs de ces matériaux. A titre de variante, la couche émissive 155 peut être une couche de nitrure de gallium intrinsèque, c'est-à-dire non intentionnellement dopée, par exemple de concentration en donneurs résiduels comprise entre 10¹⁵ et 10¹⁸ atomes/cm³, par exemple de l'ordre de 10¹⁷ atomes/cm³. Dans cet exemple, la face inférieure de la couche émissive 155 est en contact avec la face supérieure de la couche 153, et la face supérieure de la couche émissive 155 est en contact avec la face inférieure de la couche 157. En pratique, selon la nature du substrat 151, un empilement d'une ou plusieurs couches tampon (non représentées) peut faire interface entre le substrat de support 151 et la couche de nitrure de gallium 153. A titre d'exemple, dans le cas d'un substrat 151 en silicium, une couche tampon en nitrure d'aluminium peut faire interface entre le substrat 151 et la couche de nitrure de gallium 153. L'empilement actif 150 est par exemple déposé par épitaxie sur le substrat de support 151. A titre d'exemple, l'épaisseur de la couche 153 est comprise entre 0,2 et 2 µm, par exemple de l'ordre de 1 µm. A titre d'exemple, l'épaisseur de la couche 155 est comprise entre 30 et 300 nm, par exemple de l'ordre de 100 nm. A titre d'exemple, l'épaisseur de la couche 157 est comprise entre 5 et 300 nm, par exemple de l'ordre de 100 nm.

La figure 1B illustre une étape de dépôt, sur la face supérieure du circuit de contrôle 110, d'une couche 118 en un matériau électriquement isolant, par exemple en oxyde de silicium. Dans l'exemple représenté, la couche isolante 118 revêt sensiblement toute la surface supérieure du circuit de contrôle 110. En particulier, la couche isolante 118 est en contact avec les plots métalliques de connexion 113 du circuit de contrôle 110 et avec les régions isolantes 114 séparant latéralement les plots 113. Le dépôt de la couche isolante 118 peut être suivi d'une étape de planarisation de la face supérieure de la couche 118, par exemple par polissage mécanochimique (CMP), de façon à obtenir une couche 118 présentant une faible rugosité de surface, par exemple une rugosité de surface inférieure à 2 nm et de préférence inférieure à 1 nm. L'épaisseur de la couche isolante 118 (après planarisation le cas échéant) est par exemple comprise entre 20 nm et 1 µm.

La figure 1B illustre en outre une étape de dépôt, sur la face supérieure de l'empilement actif de diode 150, d'une couche métallique 159. Dans l'exemple représenté, la couche métallique 159 est déposée sur et en contact avec la face supérieure de la couche de nitrure de gallium 157. La couche métallique 159 revêt par exemple sensiblement toute la surface supérieure de l'empilement actif. La couche métallique 159 est par exemple déposée par une méthode de dépôt sous vide, par exemple par dépôt physique en phase vapeur (PVD), par pulvérisation sous vide, ou par dépôt chimique en phase vapeur (CVD) . La couche métallique 159 a notamment une fonction de reprise d'un contact électrique sur la couche semiconductrice 157 de l'empilement de LED. La couche métallique 159 peut en outre avoir une fonction de réflecteur optique. A titre d'exemple, la couche métallique 159 est en aluminium ou en argent. L'épaisseur de la couche métallique 159 est par exemple comprise entre 50 nm et 1 µm.

La figure 1B illustre de plus une étape de dépôt, sur la face supérieure de la couche métallique 159, d'une couche 161 en un matériau électriquement isolant, par exemple en le même matériau que la couche 118, par exemple en oxyde de silicium. Dans l'exemple représenté, la couche isolante 161 est déposée sur et en contact avec la face supérieure de la couche métallique 159. La couche isolante 161 revêt par exemple sensiblement toute la surface supérieure de l'empilement actif. Le dépôt de la couche isolante 161 peut être suivi d'une étape de planarisation de la face supérieure de la couche 161, par exemple par polissage mécanochimique (CMP), de façon à obtenir une couche 161 présentant une faible rugosité de surface, par exemple une rugosité de surface inférieure à 2 nm et de préférence inférieure à 1 nm. L'épaisseur de la couche isolante 161 (après planarisation le cas échéant) est par exemple comprise entre 20 nm et 1 µm.

La figure 1C illustre une étape au cours de laquelle l'empilement actif de LED au nitrure de gallium 150 est rapporté sur la face supérieure du circuit de contrôle 110. Pour cela, l'ensemble comportant le substrat de support 151 et l'empilement actif 150 peut être retourné, puis rapporté sur le circuit de contrôle 110, de façon à mettre la face supérieure (dans l'orientation de la figure 1B) de la couche isolante 161 en contact avec la face supérieure de la couche isolante 118. Au cours de cette étape, l'empilement actif 150 est fixé au circuit de contrôle 110 par l'intermédiaire des couches isolantes 161 et 118. Dans cet exemple, la fixation de l'empilement actif 150 sur le circuit de contrôle 110 est réalisée par collage direct (sans apport d'un matériau de collage additionnel, par exemple par collage moléculaire, entre la face supérieure de la couche isolante 118 et la face inférieure (dans l'orientation de la figure 1C) de la couche isolante 161. A titre de variante, la fixation des deux surfaces peut être réalisée par thermocompression, ou par toute autre méthode de fixation adaptée.

Dans cet exemple, à l'issue de l'étape de report et de fixation de l'empilement actif de LED sur le circuit de contrôle 110, l'empilement actif de LED n'est pas connecté électriquement au circuit de contrôle 110. En particulier, la couche semiconductrice inférieure 157 de l'empilement de LED est isolée électriquement des plots métalliques 113 du circuit de contrôle 110 par les couches isolantes 161 et 118.

La figure 1D illustre une étape ultérieure de retrait du substrat de support 151 de l'empilement actif de LED 150. Le substrat 151 est par exemple retiré par meulage et/ou gravure à partir de sa face opposée à l'empilement actif 150. A titre de variante, dans le cas d'un substrat 151 transparent, par exemple un substrat en saphir ou en corindon, le substrat 151 peut être détaché de l'empilement actif 150 au moyen d'un faisceau laser projeté à travers le substrat 151 depuis sa face opposée à l'empilement actif 150 (procédé de type laser lift-off). Plus généralement, toute autre méthode permettant de retirer le substrat 151 peut être utilisée. Après le retrait du substrat 151, une étape supplémentaire de gravure peut être prévue pour retirer une éventuelle couche tampon subsistant du côté de la face supérieure de la couche de nitrure de gallium 153. En outre, une partie de l'épaisseur de la couche de nitrure de gallium 153 peut être retirée, par exemple par gravure. A l'issue de cette étape, l'empilement actif 150 revêt sensiblement toute la surface du circuit de contrôle 110, sans discontinuité. A titre d'exemple, l'épaisseur de l'empilement actif 150 après le retrait du substrat de support 151 est comprise entre 0,2 et 10 µm.

La figure 1E illustre une étape, postérieure au retrait du substrat 151, de dépôt d'un masque dur 171 sur la face supérieure de l'empilement actif de LED 150. Le masque dur 171 est par exemple en oxyde de silicium ou en nitrure de silicium. A titre de variante, le masque dur 171 est constitué d'un empilement (non détaillé sur la figure) comprenant, dans l'ordre à partir de la face supérieure de la couche de nitrure de gallium de type N 153, une première couche d'oxyde de silicium, une couche intermédiaire d'arrêt de gravure, par exemple en nitrure de silicium ou en nitrure de titane, et une deuxième couche d'oxyde de silicium.

La figure 1F illustre une étape de formation d'ouvertures ou tranchées traversantes 173 dans le masque dur 171, par exemple par photolithographie puis gravure. Les tranchées 173 s'étendent depuis la face supérieure du masque dur 171 et débouchent sur la face supérieure de l'empilement actif de LED 150. Les tranchées 173 délimitent, en vue de dessus, les futures LED individuelles 176 du dispositif d'affichage. Les tranchées 173 peuvent être alignées par rapport à des repères préalablement formés sur le circuit de contrôle 110. A titre d'exemple, après le dépôt du masque dur 171 mais avant la formation des tranchées 173, des repères préalablement formés sur le substrat 111 peuvent être dégagés par gravure du masque dur 171 et de l'empilement actif 150 dans des zones périphériques de l'assemblage, ces repères servant ensuite de marques d'alignement pour le positionnement du masque de photolithographie utilisé pour réaliser les tranchées 173. Dans l'exemple représenté, chaque LED 176 est située, en projection verticale, en regard d'un unique plot métallique 113 du circuit de contrôle 110. Dans cet exemple, les tranchées 173 sont situées en regard des régions isolantes 114 de la face supérieure du circuit de contrôle 110. Plus particulièrement, dans l'exemple représenté, les tranchées 173 sont alignées sur les régions isolantes 114 de la face supérieure du circuit de contrôle 110. Autrement dit, en vue de dessus, les axes longitudinaux centraux des tranchées 173 et les axes longitudinaux centraux des régions 114 sont confondus. Dans cet exemple, les tranchées 173 ont une largeur supérieure à celle des régions isolantes 114. Autrement dit, chaque tranchée 173 est située en regard non seulement d'une bande isolante 114 séparant deux rangées ou colonnes voisines de plots métalliques 113, mais aussi en regard d'une partie périphérique des plots métalliques 113 situés de part et d'autre de la bande 114.

La figure 1G illustre une étape de prolongement des tranchées 173 dans une partie supérieure de la couche de nitrure de gallium 153 de l'empilement actif de LED 150. Dans cet exemple, lors de cette étape, les tranchées 173 sont prolongées verticalement par gravure jusqu'à un niveau intermédiaire de la couche 153, c'est-à-dire jusqu'à pénétrer partiellement dans la couche 153, sans la traverser entièrement.

La figure 1H illustre une étape ultérieure de dépôt d'une couche conductrice 178, par exemple en métal, par exemple en aluminium ou en titane, sur les parois latérales et sur le fond des tranchées 173. Dans l'exemple représenté, la couche 178 est en outre déposée sur la face supérieure des portions du masque dur 171 surmontant les LED 176. La couche 178 est par exemple déposée sur toute la surface supérieure du dispositif par une méthode de dépôt conforme, par exemple par une méthode de dépôt sous vide, par exemple par dépôt physique en phase vapeur, par pulvérisation, ou par dépôt chimique en phase vapeur. La couche métallique 178 a notamment pour fonction la reprise d'un contact électrique sur la couche semiconductrice 153 de l'empilement de LED. On notera en particulier que dans chaque LED 176 du dispositif, la couche métallique 178 est en contact avec la couche semiconductrice 153 sur toute la périphérie de la LED, au niveau des parois latérales d'une partie inférieure des tranchées 173.

La figure 1H illustre en outre une étape postérieure au dépôt de la couche métallique 178, au cours de laquelle on vient former des espaceurs 179 en un matériau isolant, par exemple en oxyde de silicium ou en nitrure, sur les parois latérales des tranchées 173. A titre d'exemple, une couche en un matériau isolant est d'abord déposée sur toute la surface supérieure du dispositif, c'est-à-dire sur les parois latérales et sur le fond des tranchées 173, ainsi que sur la face supérieure des portions du masque dur 171 surmontant les LED 176. A titre d'exemple, la couche isolante est déposée sur et en contact avec la face supérieure de la couche métallique 178, sur toute la surface du dispositif. La couche isolante peut être déposée par toute méthode de dépôt conforme adaptée. A titre d'exemple, l'épaisseur de la couche isolante est comprise entre 50 nm et 1 µm. Une étape de gravure anisotrope verticale de la couche isolante est ensuite mise en oeuvre de façon à retirer les portions horizontales de la couche isolante, au fond des tranchées 173 et sur la face supérieure des portions du masque dur 171 surmontant les LED 176, et à conserver la couche isolante uniquement sur les parois latérales des tranchées 173 pour former les espaceurs 179.

La figure 1I illustre une étape postérieure à la formation des espaceurs 179, au cours de laquelle les tranchées 173 sont prolongées, par gravure, jusqu'à un niveau intermédiaire de la couche semiconductrice inférieure 157 de l'empilement actif de LED 150. Lors de cette étape, le procédé de gravure est choisi pour graver le métal de la couche 178 et les matériaux des couches 153, 155 et 157 de façon sélective par rapport au matériau des espaceurs 179. Ainsi, les portions de la couche métallique 178 situées au fond des tranchées 173 et non surmontées par les espaceurs 179, et les portions de la couche métallique 178 situées sur les portions du masque dur 171 surmontant les LED 176 sont retirées lors de cette étape. Autrement dit, seules les portions de la couche métallique 178 revêtues par les espaceurs 179 sont conservées lors de cette étape.

La figure 1I illustre en outre une étape postérieure au prolongement des tranchées 173, au cours de laquelle on vient à nouveau former des espaceurs 181 en un matériau isolant, par exemple en oxyde de silicium ou en nitrure, sur les parois latérales des tranchées 173. De façon similaire à ce qui a été décrit précédemment en relation avec la figure 1H, une couche en un matériau isolant est d'abord déposée sur toute la surface supérieure du dispositif, par une méthode de dépôt conforme. A titre d'exemple, l'épaisseur de la couche isolante est comprise entre 50 nm et 1 µm. Une étape de gravure anisotrope verticale de la couche isolante est ensuite mise en oeuvre de façon à conserver la couche isolante uniquement sur les parois latérales des tranchées pour former les espaceurs 181.

La figure 1J illustre une étape postérieure à la formation des espaceurs 181, au cours de laquelle les tranchées 173 sont prolongées, par gravure, jusqu'à la face supérieure de la couche isolante 116 séparant les niveaux de métallisation M1 et M2 du circuit de contrôle 110. Plus particulièrement, lors de cette étape, on vient graver, au fond des tranchées 173, la portion inférieure restante de la couche semiconductrice 157, la couche conductrice 159, les couches isolantes 161 et 118, ainsi que les régions isolantes 114 et la partie périphérique des plots métalliques 113 en regard des tranchées 173. La gravure est interrompue sur la face supérieure de la couche isolante 116 séparant les niveaux métalliques M1 et M2 du circuit de contrôle 110, ou dans la couche isolante 116.

Le prolongement des tranchées 173 conduit à délimiter dans l'empilement actif 150 les différentes LED 176 du dispositif. Chaque LED 176 correspond à un îlot ou mesa formé dans l'empilement 150 et entouré latéralement par une tranchée 173. Ainsi, chaque LED 176 comprend un empilement vertical comportant, dans l'ordre à partir de la surface supérieure de la couche métallique 159, une portion de la couche de nitrure de gallium 157, correspondant à l'anode de la LED dans cet exemple, une portion de la couche émissive 155, et une portion de la couche de nitrure de gallium 153, correspondant à la cathode de la LED dans cet exemple.

La figure 1K illustre une étape ultérieure de gravure d'une partie supérieure des espaceurs 179 et 181, par exemple par gravure anisotrope verticale. Dans cet exemple, les espaceurs 179 et 181 sont gravés sur une partie supérieure des flancs du masque dur 171, mais sont conservés intacts sur la partie inférieure des flancs du masque dur 171 ainsi que sur les flancs des couches sous-jacentes 153, 155 et 157 de l'empilement de LED 150. A titre d'exemple le masque dur 171 comprend une couche intermédiaire d'arrêt de gravure, non détaillée sur la figure, permettant de graver les espaceurs plus rapidement que le masque dur 171, afin que, à l'issue de l'étape de gravure, la face supérieure des espaceurs 179 et 181 soit en retrait de la face supérieure du masque dur 171.

La figure 1L illustre une étape ultérieure de dépôt d'une couche métallique 183 sur les parois latérales et sur le fond des tranchées 173. Dans l'exemple représenté, la couche 183 est en outre déposée sur la face supérieure des portions du masque dur 171 surmontant les LED 176. La couche 183 est par exemple déposée sur toute la surface supérieure de la structure obtenue à l'issue des étapes des figures 1A à 1K, par une méthode de dépôt conforme, par exemple par une méthode de dépôt sous vide, par exemple par dépôt physique en phase vapeur, par pulvérisation, ou par dépôt chimique en phase vapeur. La couche métallique 183 a notamment pour fonction, pour chaque LED 176 du dispositif, de connecter électriquement la couche métallique de contact d'anode 159 de la LED au plot métallique de connexion correspondant 113 du circuit de contrôle 110. Toutefois, à ce stade, la couche métallique 183 connecte en outre, dans chaque LED 176, la couche métallique de contact d'anode 159 de la LED à la métallisation de contact de cathode 178 de la LED. De plus, la couche 183 connecte entre elles les régions de contact d'anode 159 des différentes LED 176 du dispositif.

La figure 1M illustre une étape ultérieure de prolongement des tranchées 173 jusqu'à la face supérieure de la région métallique de connexion 115 formée dans le niveau métallique M1 du circuit de contrôle 110. Lors de cette étape, les portions horizontales de la couche métallique 183 situées au fond des tranchées 173 sont retirées, ce qui conduit à isoler les unes des autres les régions de contact d'anode 159 des différentes LED 176 du dispositif. De plus, lors de cette étape, les portions horizontales de couche métallique 183 revêtant la face supérieure des espaceurs 179 et 181 sont retirées, ce qui conduit à isoler électriquement, dans chaque LED 176, la métallisation de contact d'anode 159 de la LED de la métallisation de contact de cathode 178 de la LED.

La figure 1N illustre une étape postérieure au prolongement des tranchées 173, au cours de laquelle on vient à nouveau former des espaceurs 185 en un matériau isolant, par exemple en oxyde de silicium ou en nitrure, sur les parois latérales des tranchées 173. De façon similaire à ce qui a été décrit précédemment en relation avec les figures 1H et 1I, une couche en un matériau isolant est d'abord déposée sur toute la surface supérieure du dispositif, par une méthode de dépôt conforme. A titre d'exemple, l'épaisseur de la couche isolante est comprise entre 50 nm et 1 µm. Une étape de gravure anisotrope verticale de la couche isolante est ensuite mise en oeuvre de façon à conserver la couche isolante uniquement sur les parois latérales des tranchées pour former les espaceurs 185. Dans cet exemple, l'épaisseur de la couche isolante et les conditions de l'étape de gravure anisotrope verticale de la couche isolante sont prévues pour que, à l'issue de l'étape de gravure, la face supérieure des espaceurs 185 soit située à un niveau intermédiaire entre le plan de la face supérieure des portions de la couche métallique 183 en contact avec les métallisations de contact d'anode 159 et avec les plots métalliques de connexion 113, et le plan de la face supérieure des métallisations de contact de cathode 178. Ainsi, pour chaque LED 176 du dispositif d'affichage, l'espaceur périphérique 185 recouvre entièrement la portion de la couche métallique 183 connectant la métallisation de contact d'anode 159 de la LED au plot métallique de connexion correspondant 113 du circuit de contrôle, mais laisse accessible la métallisation de contact de cathode 178 de la LED.

La figure 1O illustre une étape ultérieure de dépôt d'une métallisation 190 sur les parois latérales et sur le fond des tranchées 173. Dans l'exemple représenté, la métallisation 190 comble entièrement les tranchées 173. A titre d'exemple, la métallisation 190 est réalisée par un procédé de type damascène, comprenant une étape de dépôt d'une couche métallique sur toute la surface supérieure de l'assemblage sur une épaisseur suffisante pour combler les tranchées 173, suivie d'une étape de polissage mécanochimique de la face supérieure de l'assemblage pour planariser la face supérieure du dispositif et retirer les portions de la couche métallique surmontant les LED 176. Tout ou partie de l'épaisseur du masque dur 171 peut être retirée lors de cette étape. Dans l'exemple représenté, une partie de l'épaisseur du masque dur est conservée et sert de couche de passivation de la face supérieure des régions de cathode 153 des LED 176. La métallisation 190 est par exemple constituée d'une couche inférieure d'accroche, comprenant par exemple un empilement Aluminium/Titane/Nitrure de Titane/Cuivre d'épaisseur comprise entre 10 et 100 nm, par exemple d'épaisseur de l'ordre de 50 nm, et d'une couche supérieure de remplissage, par exemple en cuivre, déposée par dépôt électrochimique. La métallisation 190 connecte les métallisations de contact de cathode 178 des différentes LED 176 du dispositif les unes aux autres ainsi qu'aux régions métalliques de connexion 115 du circuit de contrôle 110. La métallisation 190 est en revanche isolée, par les espaceurs 185, de la portion de la couche métallique 183 connectant, dans chaque pixel, la métallisation de contact d'anode 159 de la LED 176 au plot de connexion 113 correspondant du circuit de contrôle. En vue de dessus, la métallisation 190 a la forme d'une grille continue entourant latéralement et séparant les uns des autres les différents pixels du dispositif.

Un avantage du procédé décrit en relation avec les figures 1A à 1O est que le collage de l'empilement actif de LED sur le circuit de contrôle (figure 1C) est un collage isolant/isolant, qui est généralement plus aisé à réaliser et présente une meilleure homogénéité que les collages métal/métal.

De plus, dans le procédé décrit en relation avec les figures 1A à 1O, l'interface de collage n'a pas de fonction électrique. Autrement dit, même si un défaut de collage local survenait lors de la fixation de l'empilement actif de LED sur le circuit de contrôle, il n'en résulterait pas un défaut de connexion électrique entre le circuit de contrôle 110 et la ou les LED 176 correspondantes du dispositif d'affichage, dans la mesure où les connexions électriques entre les LED 176 et le circuit de contrôle 110 sont réalisées postérieurement au collage.

Un autre avantage du procédé décrit en relation avec les figures 1A à 1O est qu'il présente une unique étape de photolithographie et gravure (pour définir l'emplacement des tranchées 173), ce qui le rend particulièrement simple et peu coûteux à mettre en oeuvre.

Un autre avantage de ce procédé est que le contact électrique de cathode des LED 176 est pris latéralement sur toute la périphérie des régions de cathode 153 des LED. Ceci permet de minimiser la résistance de contact de cathode, et ainsi de limiter la consommation électrique du dispositif.

Par ailleurs, la disposition des métallisations de contact de cathode 190 dans les tranchées d'isolation des LED 176 permet de maximiser la surface active du dispositif d'affichage. Cette disposition permet en outre de renforcer l'isolation optique entre les différentes LED 176, et de favoriser l'évacuation de la chaleur générée par les LED 176 en fonctionnement.

La figure 2 est une vue en coupe illustrant une variante du procédé des figures 1A à 1O. Dans l'exemple de la figure 2, la fixation de l'empilement actif de LED 150 sur le circuit de contrôle 110 par collage direct de la couche isolante 161 sur la couche isolante 118, tel que décrit en relation avec la figure 1C, est remplacée par une fixation au moyen d'une couche 218 en un matériau de collage électriquement isolant, par exemple une couche de colle organique, par exemple une couche de silicone ou une couche de polyimide. Dans l'exemple représenté, la couche de colle 218 a une face supérieure en contact avec la face inférieure de la couche métallique de reprise de contact d'anode 159, et une face inférieure en contact avec la face supérieure du circuit de contrôle 110. La couche de colle 218 est par exemple déposée sur la face supérieure du circuit de contrôle 110, ou sur la face inférieure (dans l'orientation de la figure 1C) de l'empilement actif de LED 150, ou en partie sur la face supérieure du circuit de contrôle 110 et en partie sur la face inférieure de l'empilement actif de LED 150, avant le report de l'empilement actif de LED 150 sur le circuit de contrôle 110. Les autres étapes du procédé sont par exemple identiques ou similaires à ce qui a été décrit en relation avec les figures 1A à 1O.

Un avantage de la variante de réalisation de la figure 2 est que le collage de l'empilement actif de LED 150 sur le circuit de contrôle 110 est plus simple à mettre en oeuvre que le collage direct isolant/isolant décrit en relation avec la figure 1C.

Des modes de réalisation particuliers ont été décrits. Diverses variantes et modifications apparaîtront à l'homme de l'art. En particulier, les types de conductivité des couches de nitrure de gallium 153 (de type N dans les exemples décrits) et 157 (de type P dans les exemples décrits) peuvent être inversés.

Par ailleurs, bien que l'on ait décrit uniquement des exemples de réalisation de dispositifs d'affichage à base de LED au nitrure de gallium, les modes de réalisation décrits peuvent être adaptés à la fabrication d'un capteur comportant une pluralité de photodiodes au nitrure de gallium adressables individuellement pour acquérir une image.

Plus généralement, les modes de réalisation décrits peuvent être adaptés à la fabrication de tout dispositif d'affichage ou capteur photosensible à base de diodes semiconductrices, y compris à base de matériaux semiconducteurs autres que le nitrure de gallium, par exemple des diodes à base d'autres matériaux semi-conducteurs III-V ou des diodes à base de silicium.

De plus, dans les exemples décrits, la prévision d'une couche métallique 159 sur et en contact avec la face supérieure (dans l'orientation de la figure 1B) de la couche d'anode 157 de l'empilement actif de diode 150, permet de minimiser la résistance de contact de cathode, et ainsi de limiter la consommation électrique du dispositif. A titre de variante, la couche métallique 159 peut toutefois être omise, le contact de cathode étant alors pris uniquement, dans chaque diode, sur les flancs de la région de cathode 157, via la métallisation périphérique 183 reliant les flancs de la région de cathode 157 à un plot métallique de connexion 113 du circuit de contrôle 110.

En outre, les modes de réalisation décrits ne se limitent pas aux exemples décrits ci-dessus dans lesquels la métallisation de contact de cathode 190 est connectée électriquement au circuit de contrôle 110 à l'intérieur de la matrice de pixels (via les régions de connexion métalliques 115). A titre de variante, la métallisation de contact de cathode 190 peut être connectée au circuit de contrôle 110 uniquement à la périphérie de la matrice de pixels, par l'intermédiaire d'un ou plusieurs plots de connexion périphériques du circuit de contrôle 110.

## Revendications

1. Procédé de fabrication d'un dispositif optoélectronique, comportant les étapes suivantes :
a) rapporter, sur une face de connexion d'un circuit de contrôle (110), un empilement actif de diode (150) comportant au moins des première (153) et deuxième (157) couches semiconductrices dopées de types de conductivité opposés, de façon que la deuxième couche semiconductrice (157) de l'empilement soit tournée vers la face de connexion du circuit de contrôle et soit séparée de la face de connexion du circuit de contrôle par au moins une couche électriquement isolante (118, 161 ; 218), ladite au moins une couche isolante (118, 161 ; 218) et ledit empilement actif de diode (150) s'étendant sur toute la surface du circuit de contrôle ;
b) former dans l'empilement actif des tranchées (173) délimitant une pluralité de diodes (176), les tranchées se prolongeant en outre à travers ladite au moins une couche isolante (118, 161 ; 218) et débouchant sur la face de connexion du circuit de contrôle (110) ; et
c) former dans lesdites tranchées (173) des premières métallisations (183) connectant la deuxième couche semiconductrice (157) de l'empilement à la face de connexion du circuit de contrôle (110).

2. Procédé selon la revendication 1, comprenant en outre la formation, dans lesdites tranchées (173), de deuxièmes métallisations (178) isolées des premières métallisations, en contact avec les flancs de la première couche semiconductrice (153).

3. Procédé selon la revendication 2, comprenant, successivement :
une première étape de formation partielle des tranchées (173) jusqu'à un niveau intermédiaire de la première couche semiconductrice (153) ;
une étape de dépôt d'une première couche métallique (178) sur les parois latérales des tranchées (173) ;
une étape de formation de premiers espaceurs (179) en un matériau isolant sur les parois latérales des tranchées (173) ;
une étape de prolongement des tranchées (173) jusqu'à un niveau intermédiaire de la deuxième couche semiconductrice (157) ;
une étape de formation de deuxième espaceurs (181) en un matériau isolant sur les parois latérales des tranchées (173) ;
une étape de prolongement des tranchées (173) jusqu'à la face de connexion du circuit de contrôle (110) ; et
une étape de dépôt d'une deuxième couche métallique (183) sur les parois latérales des tranchées (173),
dans lequel les premières métallisations sont formées dans la deuxième couche métallique (183) et les deuxièmes métallisations sont formées dans la première couche métallique (178) .

4. Procédé selon l'une quelconque des revendications 1 à 3, comportant en outre, avant l'étape a) :
une étape de dépôt d'une première couche isolante (118) sur toute la surface de la face de connexion du circuit de contrôle (110) ; et
une étape de dépôt d'une deuxième couche isolante (161) sur toute la surface de la deuxième couche semiconductrice (157) de l'empilement actif de diode (150),
et dans lequel, à l'étape a), l'empilement actif de diode (150) est fixé au circuit de contrôle (110) par collage direct de la première couche isolante (118) sur la deuxième couche isolante (161), ladite au moins une couche électriquement isolante étant constituée par l'empilement des première (118) et deuxième (161) couches isolantes.

5. Procédé selon la revendication 4, dans lequel les première (118) et deuxième (161) couches isolantes sont en oxyde de silicium.

6. Procédé selon l'une quelconque des revendications 1 à 3, dans lequel, à l'étape a), l'empilement actif de diode (150) est fixé au circuit de contrôle (110) au moyen d'une couche (218) en un matériau de collage électriquement isolant, constituant ladite au moins une couche isolante.

7. Procédé selon la revendication 6, dans lequel le matériau de collage électriquement isolant est une colle organique.

8. Procédé selon l'une quelconque des revendications 1 à 7, comprenant en outre, avant l'étape a), une étape de dépôt d'une couche métallique (159) sur et en contact avec toute la surface de la deuxième couche semiconductrice (157) de l'empilement actif (150).

9. Procédé selon l'une quelconque des revendications 1 à 8, dans lequel, lors de la mise en oeuvre de l'étape a), l'empilement actif (150) est supporté par un substrat de support (151) situé du côté de la première couche (153) semiconductrice opposé à la deuxième couche (157) semiconductrice, le procédé comprenant en outre, entre l'étape a) et l'étape b), une étape de retrait du substrat de support (151).

10. Procédé selon l'une quelconque des revendications 1 à 9, dans lequel lesdites diodes (176) semiconductrices sont des diodes électroluminescentes.

11. Procédé selon l'une quelconque des revendications 1 à 9, dans lequel lesdites diodes sont des photodiodes.

12. Procédé selon l'une quelconque des revendications 1 à 11, dans lequel les première (153) et deuxième (157) couches semiconductrices sont des couches de nitrure de gallium, lesdites diodes (176) étant des diodes au nitrure de gallium.

13. Procédé selon l'une quelconque des revendications 1 à 12, dans lequel le circuit de contrôle (110) est formé dans et sur un substrat semiconducteur (111).

14. Dispositif optoélectronique, comportant :
un circuit intégré de contrôle (110) comportant une face de connexion ;
sur le circuit de contrôle (110), un empilement actif (150) de diode comportant au moins des première (153) et deuxième (157) couches semiconductrices dopées de types de conductivité opposés, la deuxième couche (157) étant séparées de la face de connexion du circuit de contrôle (110) par au moins une couche isolante (118, 161 ; 218), ladite au moins une couche isolante (118, 161 ; 218) s'étendant sous toute la surface de l'empilement actif de diode ;
des tranchées (173) s'étendant dans l'empilement actif (150) et se prolongeant en outre à travers ladite au moins une couche isolante, délimitant dans l'empilement actif (150) une pluralité de diodes (176) ; et
dans lesdites tranchées (173), des premières métallisations (183) connectant la deuxième couche semiconductrice (157) de l'empilement à la face de connexion du circuit de contrôle (110).

15. Dispositif selon la revendication 14, comprenant en outre, dans lesdites tranchées (173), des deuxièmes métallisations (178) isolées des premières métallisations, en contact avec les flancs de la première couche semiconductrice (153).
